# EUROPÄISCHE PATENTSCHRIFT

(11) **EP 3 374 127 B1**
(45) Veröffentlichungstag und Bekanntmachung des Hinweises auf die Patenterteilung: **25.11.2020**
(21) Anmeldenummer: 16793746.5
(22) Anmeldetag: 24.10.2016
(51) Int. Cl.: B23Q 1/03, B25B 1/24, B25B 11/00

(54) **AUFLAGEVORRICHTUNG FÜR EINE MEHRZAHL VON BAUTEILEN UNTERSCHIEDLICHER GEOMETRIE**
SUPPORTING DEVICE FOR A PLURALITY OF COMPONENTS WITH DIFFERENT GEOMETRIES
DISPOSITIF DE SUPPORT POUR UNE PLURALITÉ D'ÉLÉMENTS DE GÉOMÉTRIES DIFFÉRENTES

(30) Priorität: 12.11.2015 DE 202015106116 U
(43) Veröffentlichungstag der Anmeldung: 19.09.2018
(73) Patentinhaber: REHAU AG + Co, 95111 Rehau (DE)
(72) Erfinder: GRUND, Bernd, 95030 Hof (DE)
(86) Internationale Anmeldenummer: PCT/EP2016/001760
(87) Internationale Veröffentlichungsnummer: WO 2017/080630

(56) Entgegenhaltungen:
- EP-A1- 0 400 765
- WO-A1-2008/001654
- WO-A1-2015/019210
- US-A- 5 457 868
- US-A1- 2009 140 482

## Beschreibung

Die Erfindung betrifft eine Auflagevorrichtung für eine Mehrzahl von Bauteilen unterschiedlicher Geometrie gemäß dem Oberbegriff des Anspruchs 1, insbesondere für eine Mehrzahl geometrisch unterschiedlicher Kfz-Außenanbauteile aus Polymermaterial. Bei diesen Kfz-Außenanbauteilen kann es sich beispielsweise um Stoßfänger oder aber auch um Längsträger, beispielsweise Schweller, oder Spoiler handeln. Vorzugsweise werden die Kfz-Außenanbauteile im bereits lackierten Zustand auf die Auflagevorrichtung aufgelegt. In diese Bauteile werden immer häufiger elektronische Elemente, wie z.B. Parksensoren, Abstandshalter und dergleichen oder aber auch Waschvorrichtungen, insbesondere zum Reinigen von Schweinwerfern, nachträglich eingebaut. Zu diesem Zweck müssen die vorzugsweise im Spritzgussverfahren hergestellten Außenanbauteile auf einer Auflage sicher positioniert werden, so dass eine einwandfreie Montage der zusätzlichen Komponenten sichergestellt werden kann.

Im Stand der Technik ist es hierzu bekannt, die Bauteile auf verformbare, beispielsweise mit Luft gefüllte Kissen aufzulegen, welche sich dann unter der Belastung an die Außengeometrie des Bauteils anpassen. Sofern jedoch Bauteile unterschiedlicher Geometrie einer der vorbeschriebenen Montageoperation unterzogen werden müssen, sind derartige Auflagevorrichtungen aufgrund ihrer begrenzten Anpassungsfähigkeit nur bedingt geeignet. Im Stand der Technik wird daher häufig für jede Bauteilgeometrie eine spezielle Auflagevorrichtung vorgehalten. Dies ist jedoch kostenintensiv und führt darüber hinaus zu einem großen Platzbedarf in der Werkshalle. Aufgrund des immer weiter zunehmenden Wettbewerbsdrucks besteht Bedürfnis, die Positionierung derartiger Bauteile mit unterschiedlicher Geometrie zur Durchführung von Montagevorgängen schnell, einwandfrei und platzsparend durchführen zu können. Auflagevorrichtungen mit den Merkmalen des Oberbegriffs des Patentanspruchs 1 sind aus WO 2008/001654 A1 bekannt. Weitere Auflagevorrichtungen für eine Mehrzahl von Bauteilen sind in WO 2015/019210 A1, US 5 457 868 A, US 2009/140482 A1 und EP 0 400 765 A1 beschrieben.

Der Erfindung liegt die Aufgabe zugrunde, eine Auflagevorrichtung der eingangs beschriebenen Art bereitzustellen, die einen einwandfreien Sitz von Bauteilen mit deutlich unterschiedlichen Geometrien ermöglicht.

Erfindungsgemäß wird diese Aufgabe gelöst durch eine Auflagevorrichtung mit den Merkmalen des Patentanspruchs 1.

Erfindungsgemäß wird also für jede konkrete Bauteil-Geometrie eine Auflagegruppe in Gestalt mehrerer Auflageelemente derart hergestellt, dass an ihrer Position an der Auflagevorrichtung deren oberer Rand jeweils genau an die entsprechende Bauteil-Geometrie angepasst ist. Durch das Betätigen des Antriebs werden zweckmäßigerweise lediglich die Auflageelemente einer einzigen Auflagegruppe derart nach oben verschoben, dass sämtliche Auflageelemente aller anderen Auflagegruppen bei einer Auflage des Bauteils nicht in Kontakt mit diesem kommen und somit die Auflageoberfläche für das konkrete Bauteil allein durch die oberen Ränder der Auflageelemente gebildet wird, welche genau an das konkrete Bauteil angepasst sind. Die Auflageelemente und damit auch entsprechend deren oberer Rand weisen zweckmäßigerweise eine Dicke von jeweils 0,5 - 10 cm, vorzugsweise 1 - 2 cm, auf.

Wechselweise können nun immer jeweils nur die Auflageelemente einer einzelnen Auflagegruppe gemeinsam so nach oben verschoben werden, dass sie eine optimal auf das konkrete Bauteil abgestimmte Auflageoberfläche bilden. Da die scheibenförmigen Auflageelemente bereits im unbelasteten Zustand an die Geometrie des zugeordneten Bauteils angepasst sind, bedarf es bei der Auflage des entsprechenden Bauteils keiner elastischen Verformung der Auflageelemente, um einen optimalen Sitz zu gewährleisten. Dies erhöht die Positionsgenauigkeit des konkreten Bauteils auf der Auflagevorrichtung, so dass eine optimale Voraussetzung für eine einwandfreie Montage von zusätzlichen Komponenten am Bauteil gegeben ist. Zweckmäßigerweise sind die Auflageelemente daher starr ausgebildet. Vorzugsweise unterscheiden sich die Konturen benachbarter Auflageelemente unterschiedlicher Auflagegruppen bereits im unbelasteten Zustand aufgrund ihrer Anpassung an unterschiedliche Bauteil-Geometrien. Hiermit kann ein sehr präziser, genau definiter Sitz des konkreten Bauteils auf der ausschließlich von den entsprechenden Auflageelementen gebildeten Auflageoberfläche sichergestellt werden.

Zweckmäßigerweise sind mindestens drei Auflagegruppen vorgesehen. Entsprechend können in diesem Fall mindestens drei unterschiedliche Bauteil-Geometrien mit exaktem Sitz auf die Auflagevorrichtung aufgelegt werden. Je nach Anforderung liegen selbstverständlich auch mehr als drei Auflagegruppen im Rahmen der Erfindung. Vorzugsweise weist jede Auflagegruppe mindestens drei voneinander beabstandete Auflageelemente, vorzugsweise mindestens sechs voneinander beabstandete Auflageelemente auf. Zweckmäßigerweise bildet also jedes Auflageelement eine Einzelfläche und die Gesamtheit aller dieser Einzelflächen bildet die Auflagefläche für das konkrete Bauteil, an das diese Auflageelemente angepasst sind.

Erfindungsgemäß weist der nach oben zeigende Rand eines Auflageelements in einer Seitenansicht ein Berg-und-Tal-Profil mit mindestens einem Berg und mindestens einem Tal auf. Mit dieser Kontur wird der im Allgemeinen recht komplexen Geometrie des aufzulegenden Bauteils Rechnung getragen; die Kontur des oberen Randes der Auflageelemente entspricht quasi einem Abdruck des ihm zugeordneten Bauteils am jeweiligen Auflageort. Zweckmäßigerweise ist zwischen zwei Auflageelementen derselben Auflagegruppe mindestens ein Auflageelement einer anderen Auflagegruppe angeordnet. Die Auflageelemente sind zweckmäßigerweise alternierend entlang des Bauteils hintereinander gereiht angeordnet, so dass die Abstände zwischen den einzelnen Auflageelementen einer Auflagegruppe bei allen Auflagegruppen gleich groß sind. Zweckmäßigerweise sind die Auflageelemente in einer Reihe nebeneinander angeordnet. Im Rahmen der Erfindung liegt es ferner, dass die Auflageelemente zumindest bereichsweise parallel zueinander ausgerichtet sind.

Gemäß einer bevorzugten Ausführungsform der Erfindung weist der Tragrahmen eine an eine Krümmung der aufzulegenden Bauteile angepasste Winkelform mit mindestens zwei winkelförmig zueinander ausgerichteten Rahmenabschnitten auf, wobei an jedem dieser Rahmenabschnitte mindestens ein Auflageelement jeder Auflagegruppe angeordnet ist. Hierdurch ist es insbesondere möglich, auch sehr große Bauteile, insbesondere Kfz-Stoßfänger, gemäß ihrer Raumkrümmung optimal auf der Auflagevorrichtung abzustützen. Zweckmäßigerweise sind die Auflageelemente senkrecht zur Ebene ihres jeweiligen Rahmenabschnittes ausgerichtet, so dass zumindest ein Auflageelement einer Auflagegruppe unter einem Winkel zu einem anderen Auflageelement derselben Auflagegruppe ausgerichtet ist.

Im Rahmen der Erfindung liegt es generell, dass die Bewegung der Auflageelemente in einer gemeinsamen Führungsvorrichtung geführt ist. Der Antrieb kann mindestens einen quer zur Ausrichtung der scheibenförmigen Auflageelemente verfahrbaren Schlitten mit mindestens zwei nach oben vorstehenden, im Verfahrrichtung voneinander beabstandeten Mitnehmern aufweisen, mittels denen lediglich die Auflageelemente einer einzigen Auflagegruppe gemeinsam anhebbar sind. Alternativ hierzu kann der Antrieb aber auch über mindestens eine Nockenwelle verfügen, welche selektiv jeweils alle Auflageelemente einer einzelnen Auflagegruppe so nach oben bewegen kann, dass diese Auflageelemente die Auflagefläche für die konkret zugeordnete Bauteil-Geometrie bilden. Zweckmäßigerweise ist eine Gruppe von Auflageelementen einer Auflagegruppe um eine konstante Strecke zu einer Gruppe von Auflageelementen einer anderen Auflagegruppe versetzt angeordnet. Hierdurch ist in vorteilhafter Weise sichergestellt, dass die Mitnehmer des entsprechend positionierten Schlittens jeweils genau nur die Auflageelemente anheben, die einer gemeinsamen Auflagegruppe angehören. Dann entspricht die genannte Strecke genau dem Verfahrweg, den der Schlitten zurücklegen muss, um von der einen zur anderen Auflagegruppe zu gelangen. Im Rahmen der Erfindung liegt es ferner, dass der Antrieb mit einem Motor ausgestattet ist. Dieser ist vorzugsweise elektrisch, pneumatisch oder hydraulisch ausgebildet.,

Im Folgenden wird die Erfindung anhand einer lediglich ein Ausführungsbeispiel darstellenden Zeichnung ausführlich erläutert. Es zeigen schematisch:
- Fig. 1:: eine Seitenansicht einer erfindungsgemäßen Auflagevorrichtung;
- Fig. 1a: die Ansicht A in Fig. 1;
- Fig. 2, 2a: die in den Fig. 1, 1a dargestellte Auflagevorrichtung in einer Auflageposition für eine erste Bauteilgeometrie;
- Fig.3, 3a: die Darstellungen gemäß Fig. 2, 2a mit aufgelegtem Bauteil;
- Fig. 4, 4a: die in den Fig. 1, 1a dargestellte Auflagevorrichtung in einer Auflageposition für eine zweite Bauteilgeometrie, die sich von der ersten Bauteilgeometrie unterscheidet;
- Fig.5, 5a: die Darstellungen gemäß Fig. 4, 4a mit aufgelegtem Bauteil;
- Fig. 6: eine weitere Ausführungsform der Erfindung;
- Fig. 7: die Darstellung gemäß Fig 6. mit aufgelegtem Bauteil

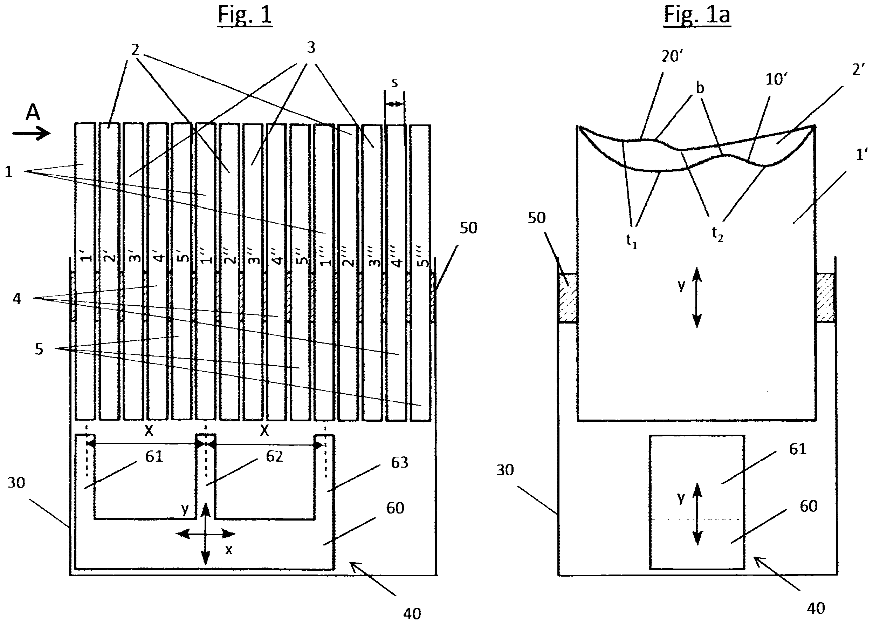

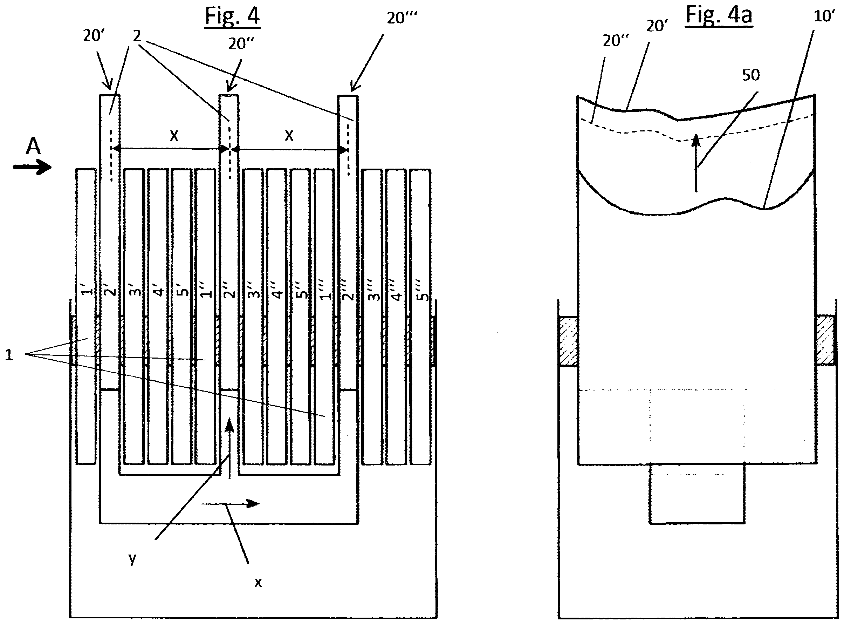

Die Figuren 1 bis 5a zeigen eine Auflagevorrichtung für eine Mehrzahl geometrisch unterschiedlicher polymerer, bereits lackierter Kfz-Stoßfänger 100, 200 etc.. Diese Auflagevorrichtung wird dafür benötigt, um an den entsprechenden Kfz-Stoßfängern 100, 200 etc. zusätzliche Komponenten, insbesondere elektrischer Art, wie z.B. Parksensoren, Abstandshalter oder aber auch Scheinwerferreinigungsdüsen und dergleichen zu montieren. Die Auflagevorrichtung weist einen Tragrahmen 30 aus Metall, einen am Tragrahmen 30 angeordneten Antrieb 40 und fünf am Tragrahmen 30 angeordnete Auflagegruppen 1, 2, 3, 4, 5 auf. Jede Auflagegruppe 1, 2, 3, 4, 5 ist als Auflagefläche für eine bestimmte Stoßfänger-Geometrie vorgesehen.

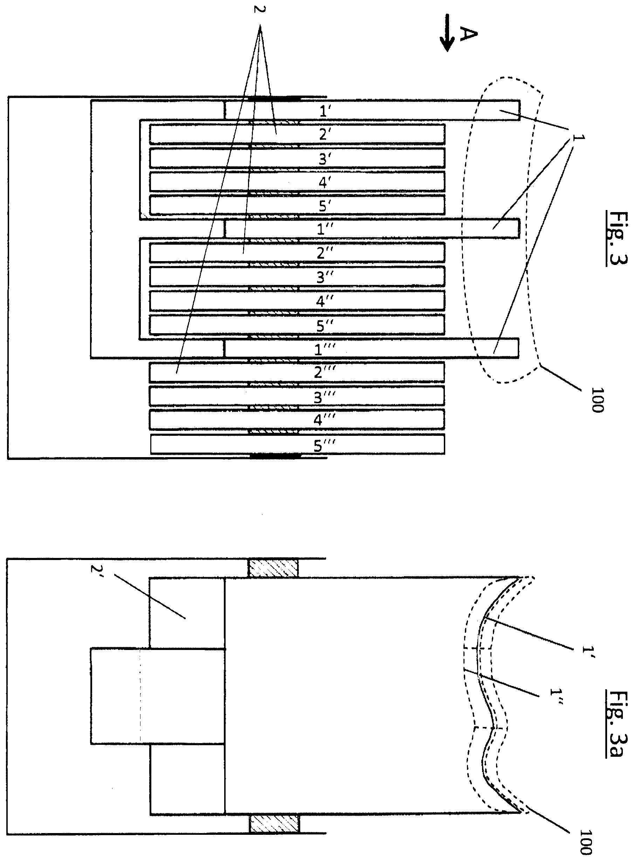

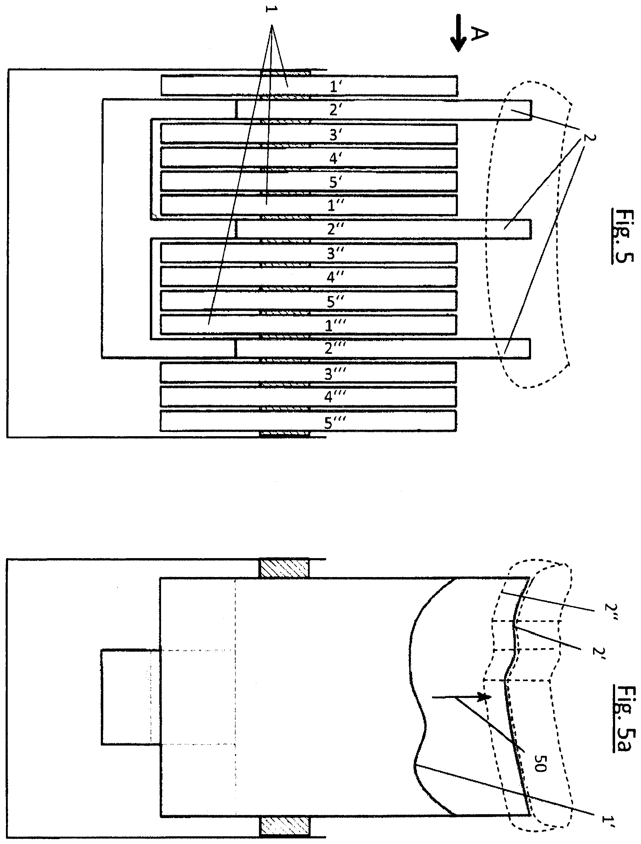

Wie den Figuren zu entnehmen ist, weist jede Auflagegruppe 1, 2, 3, 4, 5 insgesamt drei voreinander beabstandete, scheibenförmige Auflageelemente 1', 1", 1'" bzw. 2', 2", 2'" usw. auf, deren jeweils nach oben zeigender Rand 10', 10", 10"' bzw. 20, 20', 20" usw. bereits im unbelasteten Zustand eine an die Geometrie des zugeordneten Stoßfängers 100 bzw. 200 etc. angepasste Kontur aufweist. Die Auflageelemente 1', 1", 1'" bzw. 2', 2", 2'" usw. bestehen aus einem gut zuschneidbaren Material, beispielsweise einem Kunststoff und besitzen jeweils eine Dicke s von 1 bis 2 Zentimetern. Mittels des Antriebs 40 sind die Auflageelemente 1', 1", 1'" bzw. 2', 2", 2'" usw. nun derart bewegbar, dass lediglich die Auflageelemente 1', 1", 1'" oder 2', 2", 2'" usw. einer einzelnen Auflagegruppe 1, 2, 3, 4, 5 so nach oben vorstehen, dass nur die nach oben zeigenden Ränder 10', 10", 10'" bzw. 20', 20", 20'" usw. dieser Auflageelemente 1', 1", 1'" bzw. 2', 2", 2'" usw. die Auflagefläche für den ihnen zugeordneten Kfz-Stoßfänger 100 bzw. 200 etc. bilden. Dies wird insbesondere anhand einer Betrachtung der Figuren 3, 3a und 5, 5a deutlich.

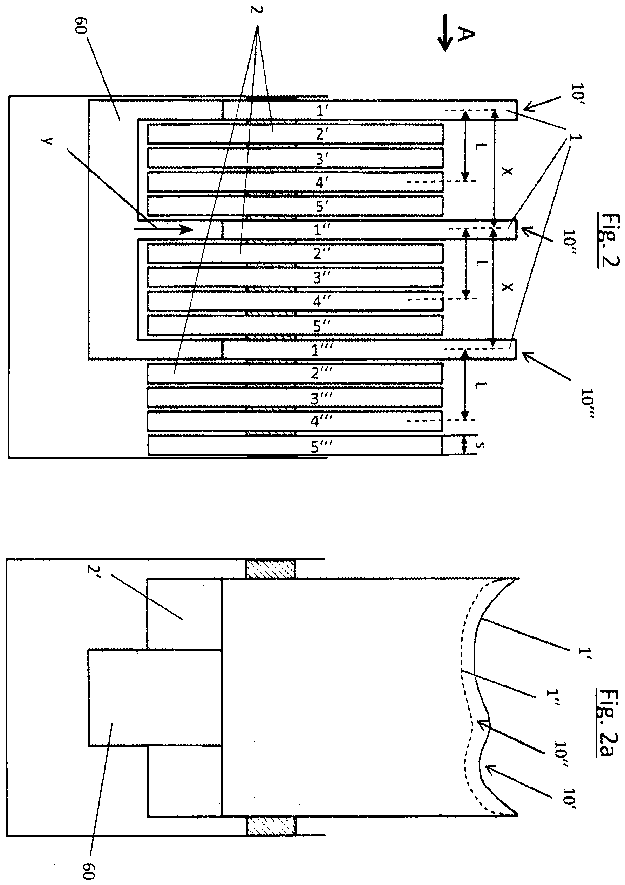

Ferner ist insbesondere anhand der Fig. 1a erkennbar, dass die Konturen der Ränder 10', 20' usw. benachbarter Auflageelemente 1', 1", 1'" bzw. 2', 2", 2'" usw. unterschiedlicher Auflagegruppen 1, 2, 3, 4, 5 sich bereits im unbelasteten Zustand aufgrund ihrer Anpassung an unterschiedliche Stoßfänger-Geometrien 100 bzw. 200 etc. voneinander unterscheiden. Die Auflageelemente 1', 1", 1'" bzw. 2', 2", 2'" usw. sind im Ausführungsbeispiel starr ausgebildet. Die Figur 1a zeigt, dass der nach oben zeigende Rand 10', 10", 10'" bzw. 20, 20', 20" usw. eines Auflageelementes 1', 1", 1'" bzw. 2', 2", 2'" usw. in einer Seitenansicht jeweils ein Berg-und-Talprofil mit einem Berg b und zwei Tälern t₁, t2 aufweist. Dieses Berg-und-Talprofil bildet sozusagen einen Abdruck der konkreten Kfz-Stoßfänger-Geometrie am entsprechenden Auflageort (s. Fig. 3a und 5a). Je nach Komplexität des aufzulegenden Bauteils 100, 200 etc. können die Profile auch sowohl mehrere Berge als auch mehrere Täler aufweisen. Den Figuren zeigen außerdem, dass zwischen zwei Auflageelementen 1', 1" bzw. 1", 1"' derselben Auflagegruppe 1 jeweils ein Auflageelement 2', 3', 4', 5' bzw. 2",3", 4", 5" aller anderen Auflagegruppen 2, 3, 4, 5 angeordnet ist. Es ist erkennbar, dass alle Auflageelemente 1', 1", 1"', 2', 2", 2"' usw. in einer Reihe nebeneinander angeordnet und auch alle parallel zueinander ausgerichtet sind. Alle Auflageelemente 1', 1", 1'" usw. der Auflagegruppe 1 usw. sind bei diesem Ausführungsbeispiel ferner um die konstante Strecke L zu den Auflageelementen 4', 4", 4"'usw. einer anderen Auflagegruppe 4 usw. versetzt angeordnet (s. Fig. 2). Dies gilt analog für alle Auflagegruppen 1, 2, 3, 4, 5. Die Vertikalbewegung der Auflageelemente 1', 1", 1'" usw. ist in einer gemeinsamen Führungsvorrichtung 50 geführt.

Der Antrieb 40 weist nun quer zur Ausrichtung der scheibenförmigen Auflageelemente 1', 1", 1'" usw. in senkrechter y-Richtung einen in horizontaler Richtung x verfahrbaren Schlitten 60 mit drei nach oben vorstehenden, in Verfahrrichtung x voneinander beabstandeten Mitnehmern 61, 62, 63 auf, mittels denen lediglich die Auflageelemente 1', 1", 1'" oder 2', 2", 2"' usw. einer einzelnen Auflagegruppe 1 oder 2 oder 3 oder 4 oder 5 gemeinsam in vertikaler Richtung y anhebbar sind. Es ist anhand einer vergleichenden Betrachtung der Fig. 1, 2 und 4 erkennbar, dass der Mittenabstand X der einzelnen Mitnehmer 61, 62, 63 in Verfahrrichtung x genau dem Mittenabstand X zwischen den einzelnen Auflageelementen 1', 1", 1"' bzw. 2', 2", 2'" usw. einer jeden Auflagegruppe 1 bzw. 2 usw. entspricht. Der Mittenabstand X zwischen z.B. den zwei Auflageelementen 1', 1" der Auflagegruppe 1 entspricht also dem Mittenabstand X zwischen den benachbarten Auflageelementen 2', 2'" der Auflagegruppe 2 und auch dem Mittenabstand X zwischen den beiden Mitnehmern 61, 62, so dass der Schlitten 60 mit den nach oben vorstehenden Mitnehmern 61, 62, 63 für eine passgenaue Mitnahme aller Auflageelemente 1', 1", 1'" oder 2', 2", 2"' usw. einer Auflagegruppe 1 oder 2 usw. geeignet ist. Ferner ist erkennbar, dass die Mittenabstände X zwischen den einzelnen Auflageelementen 1', 1", 1'" bzw. 2', 2", 2'" usw. einer Auflagegruppe 1 bzw. 2 usw. alle gleich groß sind, also z.B. der Mittenabstand X zwischen den beiden Auflageelementen 1', 1" genauso groß ist wie der zwischen den Auflageelementen 1", 1"'. Entsprechend sind die Auflageelemente 1', 1", 1'" bzw. 2', 2", 2'" usw. und auch die Mitnehmer 61, 62, 63 entlang des Verfahrwegs x gleichmäßig voneinander beabstandet. Der Antrieb 40 ist mit einem den Schlitten 60 antreibenden, nicht dargestellten Pneumatik-Motor ausgestattet, welcher den Schlitten 60 horizontal in x-Richtung und in vertikaler Richtung y verfahren kann (angedeutet durch die Doppelpfeile in Fig. 1).

Die Funktionsweise der erfindungsgemäßen Auflagevorrichtung ist nun wie folgt: Sofern ein erster Stoßfänger 100 auf die Auflagevorrichtung aufgelegt werden soll, werden über die Stellung des Schlittens 60 die Mitnehmer 61, 62, 63 genau unterhalb jenen Auflageelementen 1', 1", 1"' positioniert, welche gemeinsam die Auflagegruppe 1 bilden und deren nach oben zeigender Rand 10', 10", 10"' jeweils lokal genau an die Geometrie dieses ersten Stoßfängers 100 angepasst ist (s. Fig. 2, 2a bzw. 3, 3a). Durch ein vertikales Anheben des Schlittens 60 in y-Richtung werden nun diese, und nur diese Auflageelemente 1', 1", 1'" nach oben verschoben, so dass lediglich deren nach oben zeigenden Ränder 10', 10", 10'" gemeinsam die Auflagefläche für den ersten Stoßfänger 100 bilden. In dieser nach oben verschobenen Position werden die Auflageelemente 1', 1", 1"', z.B. durch den Schlitten, arretiert, so dass hiernach der erste Stoßfänger 100 passgenau auf die Auflagegruppe 1 aufgelegt und anschließend bearbeitet werden kann.

Sofern danach ein zweiter Stoßfänger 200 mit einer von dem ersten Stoßfänger 100 abweichenden Geometrie auf die Auflagevorrichtung aufzulegen ist, wird nun zunächst der Schlitten 60 wieder in y-Richtung in seine Verfahrposition nach unten bewegt und anschließend derart in Verfahrrichtung x bewegt, dass die Mitnehmer 61, 62, 63 direkt unterhalb den die Auflagegruppe 2 bildenden Auflageelemente 2', 2", 2"' positioniert werden, deren nach oben zeigende Ränder 20', 20", 20'" an die lokale Geometrie dieses zweiten Stoßfängers 200 angepasst sind. Anschließend wird der Schlitten 60 wieder in y-Richtung angehoben, so dass nun lediglich die Auflageelemente 2', 2", 2"' nach oben verschoben werden und lediglich deren nach oben zeigenden Ränder 20', 20", 20'" gemeinsam die Auflagefläche für den zweiten Stoßfänger 200 bilden. Sodann kann auch dieser zweite Stoßfänger 200 passgenau auf die Auflagevorrichtung aufgelegt werden. Da insgesamt fünf Auflagegruppen 1, 2 3, 4, 5 vorgesehen sind, können auf die in den Fig. 1 bis 5a dargestellte Auflagevorrichtung entsprechend fünf unterschiedliche Stoßfänger-Geometrien passgenau aufgelegt werden.

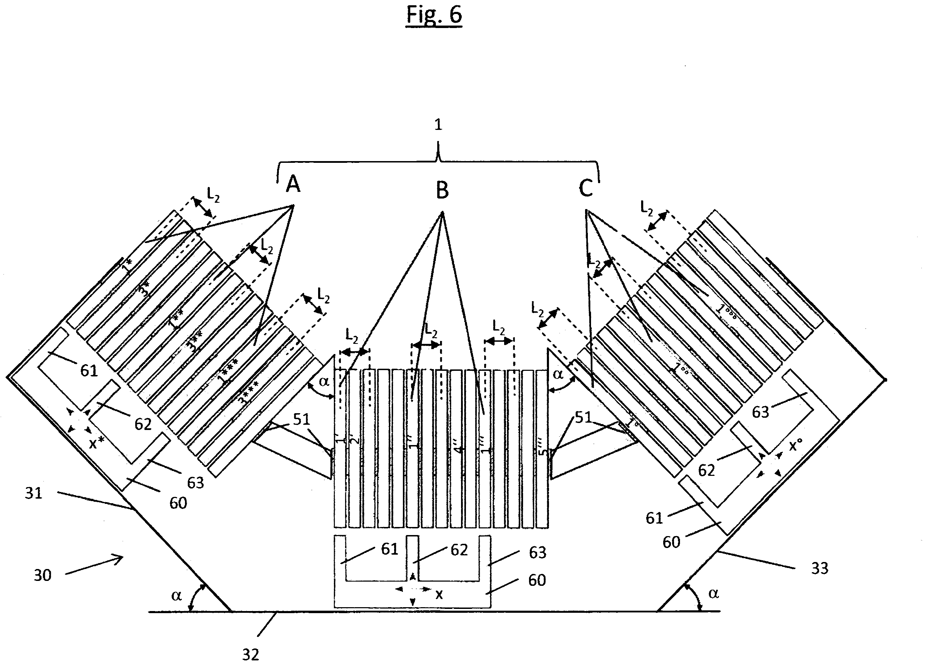

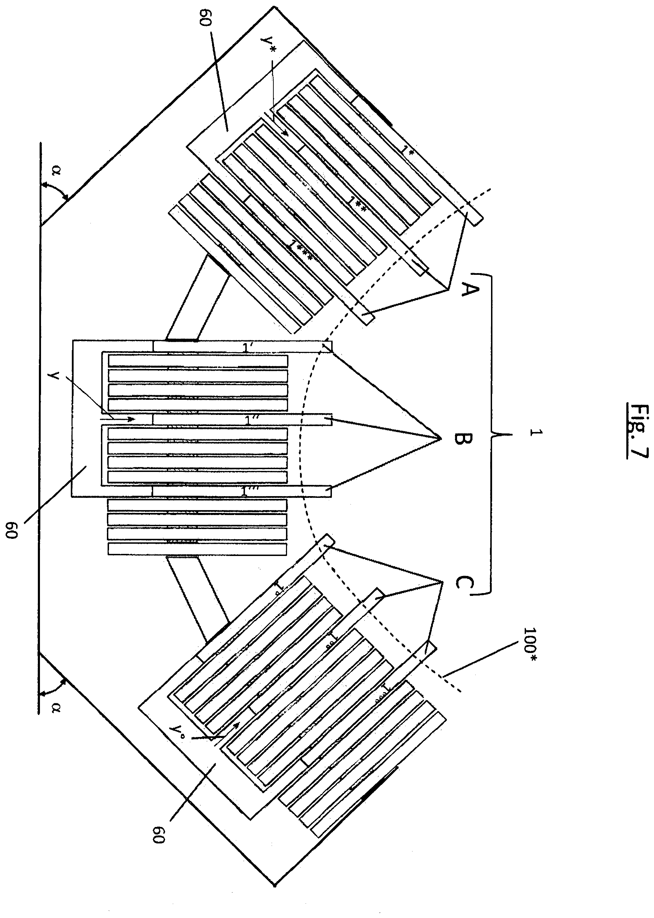

Die Figuren 6 und 7 zeigen eine alternative Ausführungsform der Erfindung. Bei dieser Ausführungsform weist der Tragrahmen 30 einen an die Krümmung eines Kfz-Stoßfängers 100* angepasste Winkelform mit drei winkelförmig zueinander ausgerichteten Rahmen-abschnitten 31, 32, 33 auf. Im Ausführungsbeispiel sind am mittleren Rahmenabschnitt 32 jeweils drei Auflageelemente 1', 1", 1'" usw. und an den beiden äußeren Rahmenabschnitten 31, 33 auch jeweils drei Auflageelemente 1*, 1**, 1*** bzw. 1°, 1°°, 1°°° usw. einer jeden Auflagegruppe 1 oder 2 usw. angeordnet (zur Erleichterung der Übersicht sind nur die Auflageelemente der Auflagegruppe 1 alle einzeln mit Bezugsziffern versehen). Hierbei schließen die beiden äußeren Rahmenabschnitte 31, 33 mit dem mittleren Rahmenabschnitt 32 jeweils den Winkel α > 0, z.B. α = 20 ÷ 60° ein. Es ist erkennbar, dass die Auflageelemente 1*, 1**, 1***, 1', 1", 1"', 1°, 1°°, 1°°° usw. jeweils senkrecht zur Ebene ihres jeweiligen Rahmenabschnittes 31, 32, 33 ausgerichtet sind, so dass die Auflageelemente 1*, 1**, 1*** bzw. 1°, 1°°, 1°°° usw. an den äußeren Rahmenabschnitten 31, 33 unter dem Winkel α zu den Auflageelementen 1', 1", 1'" usw. am mittleren Rahmenabschnitt 32 ausgerichtet sind. Die Bewegung der Auflageelemente 1*, 1**, 1***; 1', 1", 1'''; 1°, 1°°, 1°°° usw. ist in einer gemeinsamen Führungsvorrichtung 51 geführt. Es ist erkennbar, dass beim Ausführungsbeispiel gemäß Fig. 6, 7 beispielsweise die Gruppe A von Auflageelementen 1*, 1**, 1*** der Auflagegruppe 1, die an demselben Rahmenabschnitt 31 angeordnet sind, um eine konstante Strecke L₂ zur ebenfalls an diesem Rahmenabschnitt 31 angeordneten Gruppe 3*, 3**, 3*** von Auflageelementen der Auflagegruppe 3 versetzt angeordnet sind. Dies gilt analog für die dargestellte Gruppe B bestehend aus den Auflageelementen 1', 1", 1'" sowie die Gruppe C bestehend aus den Auflageelementen 1°, 1°°, 1°°°. Es sei angemerkt, dass der grundsätzliche Aufbau der Gruppe B in diesem Ausführungsbeispiel dem grundsätzlichen Aufbau der gesamten Auflagegruppe 1 im Ausführungsbeispiel gemäß den Fig. 1 bis 5a entspricht. In den Figuren 6 und 7 bilden hingegen die exemplarisch dargestellten Gruppen A, B und C gemeinsam die Auflagegruppe 1. Weiterhin sind alle an demselben Rahmenabschnitt 31, 32, 33 angeordneten Auflageelemente in einer Reihe nebeneinander angeordnet und auch alle parallel zueinander ausgerichtet.

Die Funktionsweise der in den Fig. 6, 7 dargestellten Auflagevorrichtung ist nun analog zum Ausführungsbeispiel gemäß Fig. 1 - 5 mit dem Unterschied, dass hier jedem Rahmenabschnitt 31, 32, 33 ein separater Schlitten 60 zugeordnet ist und somit insgesamt entsprechend insgesamt drei Schlitten 60 zum selektiven Anheben der Auflageelemente 1*, 1**', 1*** usw. vorgesehen sind. Die Schlitten 60 können von einem gemeinsamen Motor angetrieben sein. Alternativ kann aber auch für jeden Schlitten 60 ein separaterer Motor vorgesehen sein (jeweils nicht dargestellt). Fig. 6 zeigt die Auflagevorrichtung im Ausgangszustand und Fig. 7 die Vorrichtung mit nach oben ausgefahrenen Auflageelementen 1*, 1**', 1*** sowie 1', 1", 1"' und 1°, 1°°, 1°°° und aufgelegtem Stoßfänger 100*, wobei die genannten Auflageelemente - wie zuvor beschrieben - wiederum an die lokale Geometrie des Stoßfängers 100* am entsprechenden Auflageort angepasst sind. Während der dem mittleren Rahmenabschnitt 32 zugeordnete Schlitten 60 wiederum horizontal in x-Richtung verfahrbar ist und in vertikaler Richtung y angehoben bzw. abgesenkt wird, bewegen sich die den äußeren Rahmenabschnitten 31, 33 zugeordneten Schlitten 60 entsprechend um den Winkel α versetzt. Dies bedeutet, dass das Verfahren dieser Schlitten 60 schräg zur Horizontalen x entlang den dargestellten Richtungen x* bzw. x° und das Anheben bzw. Absenken dieser Schlitten 60 schräg zur Vertikalen y entlang den dargestellten Richtungen y* bzw. y° erfolgt.

Bei den vorstehend erläuterten Ausführungsbeispielen erfolgt stets eine sogenannte Innenmontage, d.h. dass die Innenseite des Bauteils - hier des Stoßfängers und damit auch dessen Krümmung - nach oben zeigt und frei zugänglich ist. Alternativ hierzu ist es auch möglich, die Auflagevorrichtung so auszubilden, dass die Außenseite der Bauteile nach oben zeigt und frei zugänglich ist. Bei einem gekrümmten Bauteil, beispielsweise dem in den Fig. dargestellten Stoßfänger 100, 200, 100*, würde in diesem Fall die Krümmung nach unten zeigen und in einem zu den Fig. 6 und 7 analogen Ausführungsbeispiel würde hier der mittlere Rahmenabschnitt nach oben vorstehen, während die beiden äußeren Rahmenabschnitte entsprechend nach außen hin abfallen, um sich an die nach unten zeigende Krümmung des Stoßfängers 100, 200, 100* anzupassen.

## Patentansprüche

1. Auflagevorrichtung für eine Mehrzahl von Bauteilen (100, 200, 100*) unterschiedlicher Geometrie, insbesondere für eine Mehrzahl geometrisch unterschiedlicher Kfz-Außenanbauteile aus Polymermaterial, mit
- einem Tragrahmen (30),
- einem am Tragrahmen (30) angeordneten Antrieb (40) und
- mindestens zwei am Tragrahmen (30) angeordneten Auflagegruppen (1, 2, 3, 4, 5),
wobei jede Auflagegruppe (1, 2, 3, 4, 5) als Auflagefläche für eine bestimmte Bauteil-Geometrie dient,
wobei jede Auflagegruppe (1, 2, 3, 4, 5) mindestens zwei voneinander beabstandete, scheibenförmige Auflageelemente (1', 1", 1"'; 2', 2", 2'" usw.) aufweist, deren jeweils nach oben zeigender Rand (10', 10", 10"'; 20', 20", 20'" usw.) bereits im unbelasteten Zustand eine an die Geometrie des zugeordneten Bauteils (100, 200, 100*) angepasste Kontur aufweist, und
wobei mittels des Antriebs (40) die Auflageelemente (1', 1", 1'''; 2', 2", 2'" usw.) derart bewegbar sind, dass lediglich die Auflageelemente (1', 1", 1'''; 2', 2", 2'" usw.) einer einzelnen Auflagegruppe (1, 2 usw.) so nach oben vorstehen, dass deren nach oben zeigende Ränder (10', 10", 10'"; 20', 20", 20'" usw.) die Auflagefläche für die ihnen zugeordnete Bauteil-Geometrie bilden,
**dadurch gekennzeichnet, dass** der nach oben zeigende Rand (10', 10", 10'"; 20', 20", 20'" usw.) eines Auflageelementes (1', 1", 1'"; 2', 2", 2'" usw.) in einer Seitenansicht ein Berg-und-Tal-Profil mit mindestens einem Berg (b) und mindestens einem Tal (t₁, t₂) aufweist.

2. Auflagevorrichtung nach Anspruch 1, **dadurch gekennzeichnet, dass** die Konturen benachbarter Auflageelemente (1', 2' usw.) unterschiedlicher Auflagegruppen (1, 2 usw.) sich bereits im unbelasteten Zustand aufgrund ihrer Anpassung an unterschiedliche Bauteil-Geometrien voneinander unterscheiden.

3. Auflagevorrichtung nach Anspruch 1 oder 2, **dadurch gekennzeichnet, dass** die Auflageelemente (1', 1", 1"'; 2', 2", 2'" usw.) zumindest im Wesentlichen starr ausgebildet sind.

4. Auflagevorrichtung nach einem der Ansprüche 1 bis 3, **dadurch gekennzeichnet, dass** mindestens drei Auflagegruppen (1, 2, 3, 4, 5) vorgesehen sind.

5. Auflagevorrichtung nach einem der Ansprüche 1 bis 4, **dadurch gekennzeichnet, dass** jede Auflagegruppe mindestens drei voneinander beabstandete Auflageelemente (1', 1", 1"; 2', 2", 2'" usw.), vorzugsweise mindestens sechs voneinander beabstandete Auflageelemente (1', 1", 1'"; 2', 2", 2'" usw.) aufweist.

6. Auflagevorrichtung nach einem der Ansprüche 1 bis 5, **dadurch gekennzeichnet, dass** zwischen zwei Auflageelementen (1', 1", 1"" usw.) derselben Auflagegruppe (1 usw.) ein Auflageelement (2', 2", 2"" usw.) mindestens einer anderen Auflagegruppe (2 usw.) angeordnet ist.

7. Auflagevorrichtung nach einem der Ansprüche 1 bis 6, **dadurch gekennzeichnet, dass** die Auflageelemente (1', 1", 1'''; 2', 2", 2'" usw.) in einer Reihe nebeneinander angeordnet sind.

8. Auflagevorrichtung nach einem der Ansprüche 1 bis 7, **dadurch gekennzeichnet, dass** die Auflageelemente (1', 1", 1'"; 2', 2", 2'" usw.) zumindest bereichsweise parallel zueinander ausgerichtet sind.

9. Auflagevorrichtung nach einem der Ansprüche 1 bis 8, **dadurch gekennzeichnet, dass** der Tragrahmen (30) eine an eine Krümmung der aufzulegenden Bauteile (100, 200, 100*) angepasste Winkelform mit mindestens zwei winkelförmig zueinander ausgerichteten Rahmenabschnitten (31, 32, 33) aufweist, wobei an jedem dieser Rahmenabschnitte (31, 32, 33) mindestens ein Auflageelement (1*, 1', 1° usw.) jeder Auflagegruppe angeordnet ist.

10. Auflagevorrichtung nach Anspruch 9, **dadurch gekennzeichnet, dass** die Auflageelemente (1*, 1', 1°' usw.) zumindest im Wesentlichen senkrecht zur Ebene ihres jeweiligen Rahmenabschnittes (31, 32, 33) ausgerichtet sind, so dass zumindest ein Auflageelement (1* usw.) einer Auflagegruppe (1 usw.) unter einem Winkel (α) zu einem anderen Auflageelement (1', 1° usw.) derselben Auflagegruppe (1 usw.) ausgerichtet ist.

11. Auflagevorrichtung nach einem der Ansprüche 1 bis 10, **dadurch gekennzeichnet, dass** die Bewegungen der Auflageelemente (1', 1", 1'''; 2', 2", 2'" usw.) in einer gemeinsamen Führungsvorrichtung (50, 51) geführt sind.

12. Auflagevorrichtung nach einem der Ansprüche 1 bis 11, **dadurch gekennzeichnet, dass** der Antrieb (40) mindestens einen quer zur Ausrichtung der scheibenförmigen Auflageelemente (1', 1", 1'"; 2', 2", 2'" usw.) verfahrbahren Schlitten (60) mit mindestens zwei nach oben vorstehenden, in Verfahrrichtung (x, x*, x°) voneinander beabstandeten Mitnehmern (61, 62, 63) aufweist, mittels denen lediglich die Auflageelemente (1', 1", 1'" usw.) einer einzelnen Auflagegruppe (1 usw.) gemeinsam anhebbar ist.

13. Auflagevorrichtung nach einem der Ansprüche 1 bis 12, **dadurch gekennzeichnet, dass** eine Gruppe (A, B, C) von Auflageelementen (1', 1", 1"'; 1*, 1**, 1*** usw.) einer Auflagegruppe (1 usw.) um eine konstante Strecke (L, L₂) zu einer Gruppe von Auflageelementen (4', 4", 4"'; 3*, 3**, 3*** usw.) einer anderen Auflagegruppe (4, 3 usw.) versetzt angeordnet ist.

14. Auflagevorrichtung nach einem der Ansprüche 1 bis 13, **dadurch gekennzeichnet, dass** der Antrieb (40) mit einem Elektro-, Pneumatik- oder Hydraulikmotor ausgestattet ist.

## Claims

1. Support device for a plurality of components (100, 200, 100*) of different geometry, in particular for a plurality of geometrically different motor vehicle exterior attachment components made from polymeric material, comprising:
- a support frame (30),
- a drive (40) arranged on the support frame (30) and
- at least two support groups (1, 2, 3, 4, 5) arranged on the support frame (30),
wherein each support group (1, 2, 3, 4, 5) serves as a support surface for a specific component geometry,
wherein each support group (1, 2, 3, 4, 5) has at least two plate-shaped support elements (1', 1", 1"'; 2', 2", 2"' etc.) spaced apart from one another, the upwardly pointing edge (10', 10", 10"'; 20', 20", 20"' etc.) of which in each case has a contour that is already adapted to the geometry of the assigned component (100, 200, 100*) in the unloaded state, and
wherein by means of the drive (40) the support elements (1', 1", 1'"; 2', 2", 2"' etc.) can be moved in such a manner that only the support elements (1', 1", 1"'; 2', 2", 2"' etc.) of a single support group (1, 2 etc.) project upwards such that their upwardly pointing edges (10', 10", 10'"; 20', 20", 20'" etc.) form the support surface for the component geometry assigned to them,
**characterised in that** the upwardly pointing edge (10', 10", 10'"; 20', 20", 20'" etc.) of a support element (1', 1", 1'"; 2', 2", 2'" etc.) in a side view has a hill-and-valley profile with at least one hill (b) and at least one valley (t₁, t₂).

2. Support device according to claim 1, **characterised in that** the contours of adjacent support elements (1', 2' etc.) of different support groups (1, 2 etc.) already differ from one another in the unloaded state owing to their adaptation to different component geometries.

3. Support device according to claim 1 or 2, **characterised in that** the support elements (1', 1", 1"'; 2', 2", 2"' etc.) are designed to be at least substantially rigid.

4. Support device according to one of claims 1 to 3, **characterised in that** at least three support groups (1, 2, 3, 4, 5) are provided.

5. Support device according to one of claims 1 to 4, **characterised in that** each support group (1, 2, 3, 4, 5) has at least three support elements (1', 1", 1"'; 2', 2", 2'" etc.) spaced apart from one another, and preferably at least six support elements (1', 1", 1"'; 2', 2", 2"' etc.) spaced apart from one another.

6. Support device according to one of claims 1 to 5, **characterised in that** between two support elements (1', 1", 1'" etc.) of the same support group (1 etc.), a support element (2, 2", 2"' etc.) of at least one other support group (2 etc.) is arranged.

7. Support device according to one of claims 1 to 6, **characterised in that** the support elements (1', 1", 1"'; 2', 2", 2"' etc.) are arranged in a row alongside one another.

8. Support device according to one of claims 1 to 7, **characterised in that** the support elements (1', 1", 1'"; 2', 2", 2"' etc.) are aligned parallel to one another at least in some regions.

9. Support device according to one of claims 1 to 8, **characterised in that** the support frame (30) has an angle shape adapted to a curvature of the components (100, 200, 100*) to be applied with at least two frame sections (31, 32, 33) aligned in an angular manner with respect to one another, wherein on each of these frame sections (31, 32, 33) at least one support element (1*, 1', 1° etc.) of each support group is arranged.

10. Support device according to claim 9, **characterised in that** the support elements (1*, 1', 1° etc.) are aligned at least substantially perpendicularly to the plane of their respective frame section (31, 32, 33), so that at least one support element (1* etc.) of a support group (1 etc.) is aligned at an angle (α) to another support element (1', 1° etc.) of the same support group (1 etc.).

11. Support device according to one of claims 1 to 10, **characterised in that** the movements of the support elements (1', 1", 1"'; 2', 2", 2"' etc.) are guided in a common guide device (50, 51).

12. Support device according to one of claims 1 to 11, **characterised in that** the drive (40) has at least one carriage (60) displaceable transversely to the alignment of the plate-shaped support elements (1', 1", 1'"; 2', 2", 2"' etc.) with at least two upwardly projecting carriers (61, 62, 63) spaced apart from one another in the direction of travel (x, x*, x°), by means of which only the support elements (1', 1", 1"' etc.) of a single support group (1 etc.) can be lifted together.

13. Support device according to one of claims 1 to 12, **characterised in that** a group (A, B, C) of support elements (1', 1", 1'"; 1*, 1**, 1*** etc.) of one support group (1 etc.) is arranged offset by a constant distance (L, L₂) relative to a group of support elements (4', 4", 4"'; 3*, 3**, 3*** etc.) of another support group (4, 3 etc.).

14. Support device according to one of claims 1 to 13, wherein the drive (40) is equipped with an electric, pneumatic or hydraulic motor.

## Revendications

1. Dispositif de support pour une multitude de composants (100, 200, 100*) à géométrie différente, en particulier pour une multitude de composants extérieurs de véhicule automobile à géométrie différente, composés de matériau polymère, avec
- un cadre porteur (30),
- un entraînement (40) disposé au niveau du cadre porteur (30) et
- au moins deux groupes de support (1, 2, 3, 4, 5) disposés au niveau du cadre porteur (30),
dans lequel chaque groupe de support (1, 2, 3, 4, 5) fait office de surface de support pour une géométrie de composant définie,
dans lequel chaque groupe de support (1, 2, 3, 4, 5) présente au moins deux éléments de support (1', 1", 1'" ; 2', 2", 2"', etc.) en forme de disque tenus à distance l'un de l'autre, dont respectivement le bord pointant vers le haut (10', 10", 10'" ; 20', 20", 20"', etc.) présente déjà dans l'état non soumis à une contrainte un contour adapté à la géométrie du composant (100, 200, 100*) associé, et
dans lequel les éléments de support (1', 1", 1'" ; 2', 2", 2"', etc.) peuvent être déplacés au moyen de l'entraînement (40) de telle manière que seulement les éléments de support (1', 1", 1'" ; 2', 2", 2"', etc.) d'un groupe de support (1, 2, etc.) individuel font saillie vers le haut de telle sorte que leurs bords pointant vers le haut (10', 10", 10'" ; 20', 20", 20"', etc.) forment la surface de support pour la géométrie de composant qui leur est associée, **caractérisé en ce que** le bord pointant vers le haut (10', 10", 10"' ; 20', 20", 20"', etc.) d'un élément de support (1', 1", 1'" ; 2', 2", 2"', etc.) présente dans une vue latérale un profil en pic et en creux avec au moins un pic (b) et au moins un creux (t₁, t2).

2. Dispositif de support selon la revendication 1, **caractérisé en ce que** les contours d'éléments de support (1', 2', etc.) adjacents de différents groupes de support (1, 2, etc.) se distinguent les uns des autres déjà dans l'état non soumis à une contrainte en raison de leur adaptation aux différentes géométries de composant.

3. Dispositif de support selon la revendication 1 ou 2, **caractérisé en ce que** les éléments de support (1', 1", 1'" ; 2', 2", 2"', etc.) sont réalisés au moins sensiblement de manière rigide.

4. Dispositif de support selon l'une quelconque des revendications 1 à 3, **caractérisé en ce qu'**au moins trois groupes de support (1, 2, 3, 4, 5) sont prévus.

5. Dispositif de support selon l'une quelconque des revendications 1 à 4, **caractérisé en ce que** chaque groupe de support présente au moins trois éléments de support (1', 1", 1'" ; 2', 2", 2"', etc.) tenus à distance les uns des autres, de préférence au moins six éléments de support (1', 1", 1'" ; 2', 2", 2"', etc.) tenus à distance les uns des autres.

6. Dispositif de support selon l'une quelconque des revendications 1 à 5, **caractérisé en ce qu'**un élément de support (2', 2", 2"', etc.) d'au moins un autre groupe de support (2, etc.) est disposé entre deux éléments de support (1', 1", 1"', etc.) du même groupe de support (1, etc.).

7. Dispositif de support selon l'une quelconque des revendications 1 à 6, **caractérisé en ce que** les éléments de support (1', 1", 1'" ; 2', 2", 2'", etc.) sont disposés en une rangée côte à côte.

8. Dispositif de support selon l'une quelconque des revendications 1 à 7, **caractérisé en ce que** les éléments de support (1', 1", 1'" ; 2', 2", 2"', etc.) sont orientés au moins par endroits de manière parallèle les uns par rapport aux autres.

9. Dispositif de support selon l'une quelconque des revendications 1 à 8, **caractérisé en ce que** le cadre porteur (30) présente une forme angulaire adaptée à une incurvation des composants (100, 200, 100*) à placer avec au moins deux sections de cadre (31, 32, 33) orientées l'une par rapport à l'autre de manière à former un angle, dans lequel au moins un élément de support (1*, 1', 1°, etc.) de chaque groupe de support est disposé au niveau de chacune desdites sections de cadre (31, 32, 33).

10. Dispositif de support selon la revendication 9, **caractérisé en ce que** les éléments de support (1*, 1', 1°', etc.) sont orientés au moins sensiblement de manière perpendiculaire par rapport au plan de leur section de cadre (31, 32, 33) respective de sorte qu'au moins un élément de support (1*, etc.) d'un groupe de support (1, etc.) est orienté selon un angle (α) par rapport à un autre élément de support (1', 1°, etc.) du même groupe de support (1, etc.).

11. Dispositif de support selon l'une quelconque des revendications 1 à 10, **caractérisé en ce que** les déplacements des éléments de support (1', 1", 1'" ; 2', 2", 2"', etc.) sont guidés dans un dispositif de guidage (50, 51) commun.

12. Dispositif de support selon l'une quelconque des revendications 1 à 11, **caractérisé en ce que** l'entraînement (40) présente au moins un chariot (60) pouvant être déplacé de manière transversale par rapport à l'orientation des éléments de support (1', 1", 1'" ; 2', 2", 2"', etc.) en forme de disque avec au moins deux entraîneurs (61, 62, 63) faisant saillie vers le haut, tenus à distance les uns des autres dans la direction de déplacement (x, x*, x°), au moyen desquels seulement les éléments de support (1', 1", 1'", etc.) d'un groupe de support (1, etc.) individuel peuvent être soulevés conjointement.

13. Dispositif de support selon l'une quelconque des revendications 1 à 12, **caractérisé en ce qu'**un groupe (A, B, C) d'éléments de support (1', 1", 1'" ; 1*, 1**, 1***, etc.) d'un groupe de support (1, etc.) est disposé de manière décalée d'une distance parcourue (L, L₂) constante par rapport à un groupe d'éléments de support (4', 4", 4'" ; 3*, 3**, 3***, etc.) d'un autre groupe de support (4, 3, etc.).

14. Dispositif de support selon l'une quelconque des revendications 1 à 13, **caractérisé en ce que** l'entraînement (40) est équipé d'un moteur électrique, pneumatique ou hydraulique.
